# EUROPEAN PATENT APPLICATION

(11) **EP 1 369 992 A2**
(43) Date of publication of application: **10.12.2003**
(21) Application number: 03101305.5
(22) Date of filing: 12.05.2003
(51) Int. Cl.: H03F 3/45

(54) **Amplifier and radio frequency tuner**

(30) Priority: 16.05.2002 GB 0211174
(71) Applicant: Zarlink Semiconductor Limited, Swindon, Wiltshire SN2 2QW (GB)
(72) Inventor: LAURIA, Franco, SN2 7QR, Swindon (GB); COWLEY, Nicholas, Paul, SN4 0RT, Wroughton (GB)
(74) Representative: Robinson, John Stuart

(57) **Abstract**

An amplifier, for example for use as an LNA of a radio frequency tuner, comprises a differential amplifying stage (1-5) provided with an AGC core (6-9). The output signals are formed across load resistors (10, 11) at differential outputs (OUT+, OUT-). Compensating stages (15, 16) sum the signals at the differential outputs (OUT+, OUT-) and subtract the resulting sum signal from the output signals so as to cancel the common mode signals including second order distortion products.

## Description

The present invention relates to an amplifier for a radio frequency tuner and to a radio frequency tuner incorporating such an amplifier. Such tuners may be used for broadband applications, for example as cable set top boxes.

Radio frequency tuners for receiving broadband signals, for example from terrestrial aerials, cable distribution systems and satellite aerial systems, frequently have an input stage in the form of a low noise amplifier (LNA) incorporating an automatic gain control (AGC) function. There is often little or no filtering ahead of such an LNA, which therefore receives a whole spectrum of channels available for reception with actual channel selection being performed downstream of the LNA.

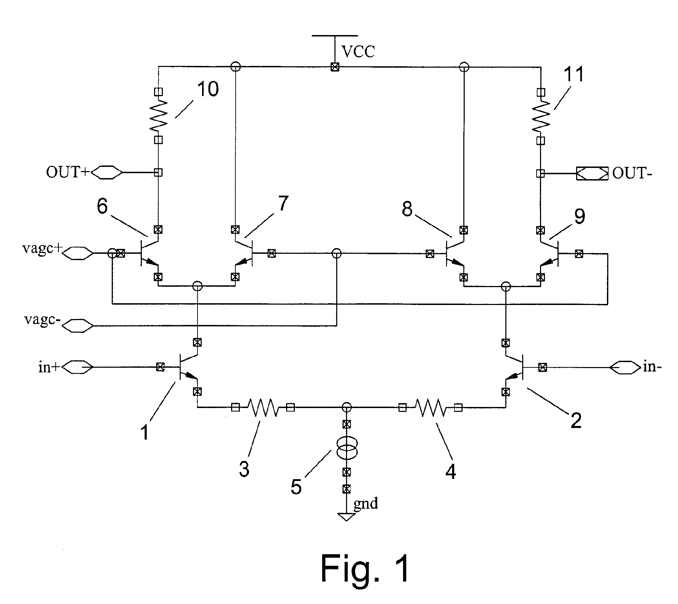

Figure 1 of the accompanying drawings illustrates a typical differential LNA incorporating an AGC function. The LNA comprises a long tail pair of NPN bipolar junction transistors 1 and 2, whose bases are connected to differential inputs IN+ and IN-. The emitters of the transistors 1 and 2 are connected via emitter degeneration resistors 3 and 4 to a first terminal of a constant current source 5, whose second terminal is connected to ground gnd. The collectors of the transistors 1 and 2 are connected to an "AGC core" comprising NPN bipolar junction transistors 6 to 9. The emitters of the transistors 6 and 7 are connected to the collector of the transistor 1 and the emitters of the transistors 8 and 9 are connected to the collector of the transistor 2. The bases of the transistors 6 and 9 are connected to a first gain control input vagc+ and the bases of the transistor 7 and 8 are connected to a second gain control input vagc-. The collectors of the transistors 6 and 9 are connected to differential outputs OUT+ and OUT-, respectively, and via load resistors 10 and 11, respectively, to a supply line vcc. The collectors of the transistors 7 and 8 are connected to the supply line vcc.

In use, for example as the first stage of a tuner, the inputs IN+ and IN- are connected to receive broadband signals, for example from a cable distribution system, and the gain control inputs vagc+ and vagc- receive a control voltage for controlling the gain of the amplifier. The long tail pair converts the differential input voltage into differential collector currents, which are steered through the load resistors 10 and 11 in accordance with the control voltage, for example derived from signal level detection so as to present a relatively constant power level to the next stage of the tuner. The differential output signals are developed across the load resistors 10 and 11 and supplied at the differential outputs OUT+ and OUT-.

The desired output signal appears as a differential signal between the outputs OUT+ and OUT- with the output signals at these outputs being 180° out of phase with each other. Any common mode signals at the inputs or developed within the amplifier also appear at the outputs OUT+ and OUT- but are in phase with each other. For example, even order distortion components generated within the amplifier appear in phase with each other at the outputs OUT+ and OUT- whereas odd order components are out of phase.

If the next stage to which the amplifier is connected has differential inputs, such as a differential amplifier, frequency changer, balun or the like and the next stage has a very high common mode rejection ratio, the common mode signals including the even order distortion components are rejected. However, in wide bandwidth systems, it is common for the common mode rejection ratio to be insufficient, particularly at relatively high frequencies, so that at least some of the even order distortion components generated in the amplifier remain and are a potential source of interference in the tuner.

If the next stage to which the amplifier is connected has a single-ended input connected to only one of the outputs OUT+ and OUT-, there is no rejection of the common mode signal and, in particular, the second order distortion products. These products therefore remain and are a potential source of interference.

In order to improve the distortion performance and to achieve a good noise figure, the amplifier shown in Figure 1 may be operated with a relatively large standing or quiescent current. However, this results in a relatively large power demand and is disadvantageous.

It has also been discovered that the presence of the AGC core can give rise to increased second order distortion products. In particular, it has been found that, as the gain of the amplifier is reduced, the second order distortion products increase.

According to a first aspect of the invention, there is provided an amplifier for a radio frequency tuner, comprising a differential amplifier stage having differential outputs, characterised by comprising a first compensating stage for summing the output signals at the differential outputs to form a sum signal and for subtracting the sum signal from the output signal at a first of the differential outputs.

The amplifier may comprise a second compensating stage for subtracting the sum signal from the output signal at a second of the differential outputs.

The amplifier stage may comprise a long tail pair of first and second amplifying devices. The amplifier stage may comprise a constant current tail source. Each of the first and second amplifying devices may have a first common terminal degeneration resistance.

The amplifier stage may comprise a variable gain stage connected to the differential outputs. The variable gain stage may comprise third to sixth amplifying devices, the third and fourth amplifying devices having common terminals connected to a first signal input, the fifth and sixth amplifying devices having common terminals connected to a second signal input, the third and sixth amplifying devices having control terminals connected to a first gain control input, the fourth and fifth amplifying devices having control terminals connected to a second gain control input, and the third and sixth amplifying devices having output terminals connected to the differential outputs. The first and second signal inputs may be connected to output terminals of the first and second amplifying devices, respectively.

The or each compensating stage may comprise a further amplifying device. The further amplifying device may have a control terminal connected via first and second resistances to the differential outputs. The further amplifying device may have a second common terminal degeneration resistance. The value of the second degeneration resistance may be substantially equal to the value of the first degeneration resistance. The further device and the amplifying stage may have a common load resistance. Each amplifying device may comprise a transistor, such as a bipolar junction transistor or a field effect transistor. When referring to amplifying devices, the "control terminal" refers to the terminal of the device which controls the flow of current between the "common" and "output" terminals and the signal at the output terminal is inverted with respect to the signal at the control terminal.

The amplifier may comprise a low noise amplifier.

According to a second aspect of the invention, there is provided a radio frequency tuner comprising at least one amplifier as claimed in any one of the preceding claims. For example, the tuner may comprise an LNA and/or an intermediate frequency amplifier embodied in accordance with the first aspect of the invention.

It is thus possible to provide an amplifier which is suitable for use in a radio frequency tuner and which has improved distortion performance. In particular, the second order distortion performance can be substantially improved so that the amplifier provides an output signal of improved signal-to-noise-plus-distortion. This may be achieved without requiring large power consumption in the amplifier.

The invention will be further described, by way of example, with reference to the accompanying drawings, in which:
Figure 1 is a circuit diagram of a known type of LNA;
Figure 2 is a partly schematic circuit diagram of an LNA constituting an embodiment of the invention;
Figure 3 is a circuit diagram of the LNA of Figure 2; and
Figure 4 is a block schematic diagram of a radio frequency tuner including two stages embodied as illustrated in Figures 2 and 3.

Like reference numerals refer to like parts throughout the drawings.

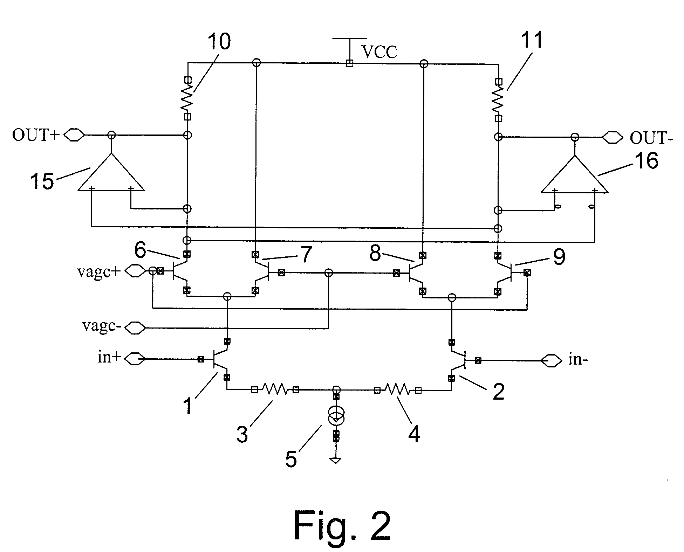

The amplifier shown in Figure 2 is of the same type as that shown in Figure 1 and comprises a differential or long tail pair amplifying stage 1-5 connected to an AGC core 6-9. However, the amplifier of Figure 2 differs from that of Figure 1 in that first and second compensating stages 15 and 16 are provided for reducing the second order distortion products. Each of the stages 15 and 16 comprises an inverting summing amplifier having two summing inputs connected to the differential outputs and an output also connected to the differential outputs OUT+ and OUT-. The stages 15 and 16 form the arithmetic sums of the differential output signals. The desired signals are 180° out of phase at the differential outputs and so substantially cancel each other out. The common mode signals including second order distortion products are in phase at the differential outputs and are therefore added together. The resulting sum signal is inverted in phase by the stages 15 and 16 and "added" to the differential signals so that the common mode signals including the second order distortion products are substantially cancelled out at the differential outputs OUT+ and OUT-. The second order distortion components are thus substantially removed or greatly reduced in level whereas the wanted signal is substantially unaffected.

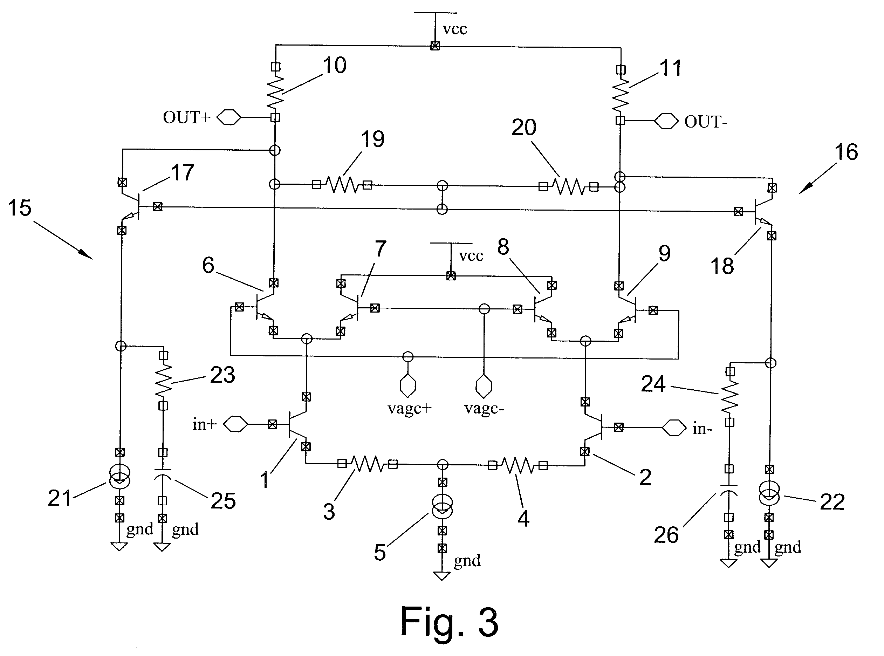

Figure 3 illustrates a particular example of the compensating stages 15 and 16. These stages comprise NPN bipolar junction transistors 17 and 18, both of whose bases are connected to the outputs OUT+ and OUT- by resistors 19 and 20. The collectors of the transistors 17 and 18 are connected to the outputs OUT+ and OUT- and share the load resistors 10 and 11 with the transistors 1 and 2 (via the AGC core 6-9). The emitters of the transistors 17 and 18 are connected via constant current sources 21 and 22, respectively, to ground gnd and are provided with emitter degeneration resistors 23 and 24, respectively. The resistors 23 and 24 are connected to ground gnd via DC-blocking capacitors 25 and 26, respectively.

The signals appearing at the differential outputs OUT+ and OUT- are summed via the resistors 19 and 20 at the bases of the transistors 17 and 18. The resulting sum signal is converted into corresponding currents with opposite phase and these are effectively subtracted from the output currents of the transistors 1 and 2 via the transistors 6 and 9 so that the common mode signals including second order distortion products are effectively cancelled or greatly reduced in amplitude at each of the differential outputs OUT+ and OUT-. The compensating stages may be embodied relatively simply as shown in Figure 3 because they are required to handle relatively low level common mode signals, for example 30dB or more lower than the differential signal. Thus, there is little increase in complexity compared with known amplifiers and the additional power consumption required by the stages is relatively small. A substantial improvement in performance may therefore be achieved with minimal extra cost, power consumption and inconvenience while not substantially degrading any aspect of performance of the amplifier.

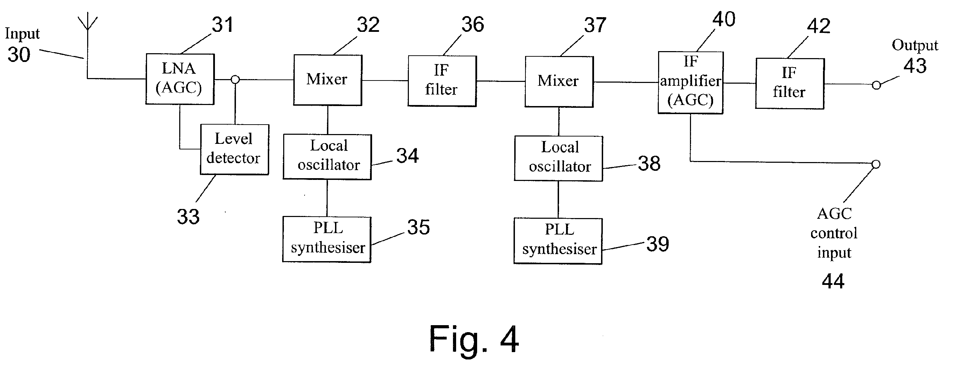

Figure 4 illustrates by way of example a typical radio frequency tuner arrangement. The tuner has an input 30, for example for connection to a terrestrial aerial, a cable distribution system or a satellite aerial system, connected to an LNA 31 incorporating an AGC arrangement in the form of a variable gain cell. The output of the LNA 31 is connected to a mixer 32 and to the input of a level detector 33 whose output controls the gain of the LNA 31. The mixer is connected to a local oscillator 34 controlled by a phase locked loop (PLL) synthesiser 35 and performs frequency conversion of a channel selected for reception to a first intermediate frequency. The output of the mixer 32 is supplied to an intermediate frequency (IF) filter 36, which is of bandpass type and which passes the selected channel and adjacent channels while substantially rejecting other channels. The output of the filter 36 is supplied to a second mixer 37 connected to another local oscillator 38 controlled by another PLL synthesiser 39. The mixer 37 converts the selected channel to a second intermediate frequency and the converted signal is supplied to an IF amplifier 40 having an AGC function. The output of the amplifier 40 is connected to a second IF filter 42, which passes the selected channel at the second intermediate frequency and substantially rejects the other remaining channels in the signal from the amplifier 40. The filtered signal is supplied via a tuner output 43 to a demodulator (not shown). The demodulator supplies control signals to an AGC control input 44 and these are used to control the gain of the amplifier 40.

The LNA 31 comprises an amplifier as shown in Figures 2 and 3. Because of the wide range of input signals which must be handled by the LNA 31, it is required to have a good distortion performance. The amplifier of Figures 2 and 3 ensures a good second order distortion performance irrespective of whether the mixer 32 has differential or single-ended inputs and in the former case, irrespective of the common mode rejection ratio of the mixer 32. In the example shown, the LNA 31 is used to supply a relatively constant signal level to the input of the mixer 32. The level detector 33 monitors the signal level and supplies control signals to the control inputs vagc+ and vagc- so as to vary the gain to achieve the relatively constant signal level.

The IF amplifier 40 also comprises an amplifier as shown in Figures 2 and 3. The AGC function of the amplifier 40 is shown as being controlled by the demodulator in accordance with demodulation requirements. However, the AGC function performed by the amplifiers 31 and 40 may be controlled in any desired way.

## Claims

1. An amplifier for a radio frequency tuner, comprising a differential amplifier stage (1-11) having differential outputs (OUT+, OUT-), **characterised by** comprising a first compensating stage (15) for summing the output signals at the differential outputs (OUT+, OUT-) to form a sum signal and for subtracting the sum signal from the output signal at a first (OUT+) of the differential outputs (OUT+, OUT-).

2. An amplifier as claimed in claim 1, **characterised by** comprising a second compensating stage (16) for subtracting the sum signal from the output signal at a second (OUT-) of the differential outputs (OUT+, OUT-).

3. An amplifier as claimed in claim 1 or 2, **characterised in that** the amplifier stage (1-11) comprises a long tail pair of first and second amplifying devices (1,2).

4. An amplifier as claimed in claim 3, **characterised in that** the amplifier stage (1-11) comprises a constant current tail source (5).

5. An amplifier as claimed in claim 3 or 4, **characterised in that** each of the first and second amplifying devices (1,2) has a first common terminal degeneration resistance (3,4).

6. An amplifier as claimed in any one of the preceding claims, **characterised in that** the amplifier stage (1-11) comprises a variable gain stage (6-9) connected to the differential outputs (OUT+, OUT-).

7. An amplifier as claimed in claim 6, **characterised in that** the variable gain stage (6-9) comprises third to sixth amplifying devices (6-9), the third and fourth amplifying devices (6,7) having common terminals connected to a first signal input, the fifth and sixth amplifying devices (8,9) having common terminals connected to a second signal input, the third and sixth amplifying devices (6,9) having control terminals connected to a first gain control input (vagc+), the fourth and fifth amplifying devices (7,8) having control terminals connected to a second gain control input (vagc-), and the third and sixth amplifying devices (6,9) having output terminals connected to the differential outputs (OUT+, OUT-).

8. An amplifier as claimed in claim 7 when dependent on any one of claims 3 to 5, **characterised in that** the first and second signal inputs are connected to output terminals of the first and second amplifying devices (1,2), respectively.

9. An amplifier as claimed in any one of the preceding claims, **characterised in that** the or each compensating stage (15,16) comprises a further amplifying device (17,18).

10. An amplifier as claimed in claim 9, **characterised in that** the further amplifying device (17,18) has a control terminal connected via first and second resistances (19,20) to the differential outputs (OUT+, OUT-).

11. An amplifier as claimed in claim 9 or 10, **characterised in that** the further amplifying device (17,18) has a second common terminal degeneration resistance (23,24).

12. An amplifier as claimed in claim 11 when dependent on claim 5, **characterised in that** the value of the second degeneration resistance (23,24) is substantially equal to the value of the first degeneration resistance (3,4).

13. An amplifier as claimed in any one of claims 9 to 12, **characterised in that** the further amplifying device (17,18) and the amplifier stage (1-11) have a common load resistance (10,11).

14. An amplifier as claimed in any one of claims 3 to 5 and 7 to 13, **characterised in that** each amplifying device (1,2,6-9,17,18) comprises a transistor.

15. An amplifier as claimed in any one of the preceding claims, **characterised by** comprising a low noise amplifier.

16. A radio frequency tuner **characterised by** comprising at least one amplifier (1-26) as claimed in any one of the preceding claims.
